# EUROPEAN PATENT APPLICATION

(11) **EP 0 844 668 A2**
(43) Date of publication of application: **27.05.1998**
(21) Application number: 97120657.8
(22) Date of filing: 25.11.1997
(51) Int. Cl.: H01L 29/78, H01L 29/51

(54) **MOS structure of semiconductor device and method of manufacturing the same**

(30) Priority: 25.11.1996 JP 313657/96
(71) Applicant: MATSUSHITA ELECTRONICS CORPORATION, Takatsuki-shi, Osaka 569-1143 (JP)
(72) Inventor: Kubo, Hiroko, Yawata-shi, Kyoto 614 (JP); Yoneda, Kenji, Kyoto 601 (JP)
(74) Representative: Grünecker, Kinkeldey, Stockmair & Schwanhäusser Anwaltssozietät

(57) **Abstract**

In a semiconductor device including a semiconductor layer, an insulating film and a conductive film formed successively in the vertical direction, the insulating film is made from a silicon dioxide film including nitrogen atoms, and has a peak point in the concentration distribution of the nitrogen atoms in the silicon dioxide film in the vicinity of the interface close to the semiconductor layer. The concentration of the nitrogen atoms at the peak point in the concentration distribution of the nitrogen atoms is 1.5 atom% or more and 5 atom% or less.

## Description

### BACKGROUND OF THE INVENTION

The present invention relates to a semiconductor device having a MIS (metal insulator semiconductor) structure in which a semiconductor layer, an insulating film and a conductive film are formed successively in the vertical direction.

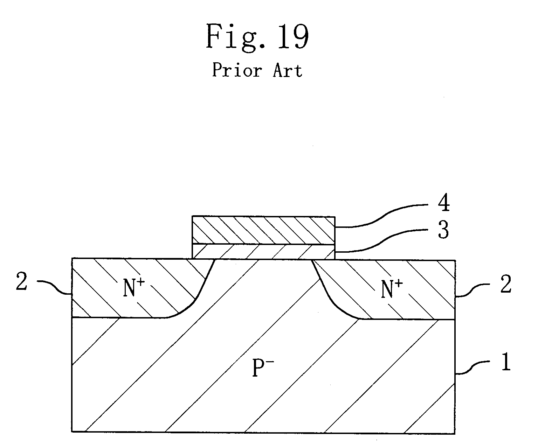

Figure 19 is a cross-sectional view of a conventional MIS structure. As is shown in Figure 19, in a semiconductor substrate 1 made from, for example, P⁻ type silicon, an isolation region (not shown) is formed through pyrogenic oxidation of the semiconductor substrate 1 at a high temperature of approximately 1000°C, and between the isolation regions, N⁺ type high concentration impurity regions 2 serving as source/drain are formed with a predetermined distance therebetween. Between the high concentration impurity regions 2 on the semiconductor substrate 1, a gate insulating film 3 is formed, and on the gate insulating film 3, a gate electrode 4 is formed out of, for example, polycrystalline silicon doped with an impurity at a high concentration.

In a transistor having the aforementioned MIS structure, with the semiconductor substrate 1 grounded and with a voltage applied to the gate electrode 4 in a charging direction, when the applied voltage is increased, an FN (Fowler Nordhein) tunnel current flows through the gate insulating film 3. When the current density of the FN tunnel current flowing through the gate insulating film 3 exceeds a predetermined value, a sudden voltage decrease is caused at an initial stage owing to formation of hole traps, and thereafter, the applied voltage gradually increases as the current injection is continued. This reveals that application of an FN tunnel current forms electron traps in the gate insulating film 3. Such formation of the electron traps degrades the dielectric and interface characteristics of the gate insulating film 3. Since an interfacial level density is remarkably increased after the injection of an FN tunnel current, it is considered that one of the main causes of the formation of the traps is dangling bonds or broken bonds, present in the vicinity of the interface between the gate insulating film 3 and the semiconductor substrate 1, working as trap sites for electrons.

On the other hand, as the thickness of the gate insulating film 3 is decreased, an electric field applied to the gate insulating film 3 is increased, and accordingly, the number of the traps formed within the gate insulating film 3 and on the interface between the gate insulating film 3 and the semiconductor substrate 1 is also increased. Therefore, there arises a first problem that the gate insulating film 3 is rapidly degraded in its insulating property.

Furthermore, the gate electrode 4 is generally made from a polysilicon film doped with an impurity, and when the polysilicon film is doped with an impurity having a large diffusion coefficient, such as boron, the impurity is diffused through the gate insulating film 3 into the semiconductor substrate 1 in a subsequent heating process. Thus, there arises a second problem that the diffused impurity harmfully affects the characteristic of a transistor to be manufactured.

As a countermeasure against this problem, for example, US Patent Nos. 5,237,188 and 5,489,542 describe a semiconductor device comprising a gate insulating film 3 including nitrogen atoms. When the nitrogen atoms are thus introduced into the gate insulating film 3, the introduced nitrogen atoms form rigid bonds with the dangling bonds and the broken bonds of silicon present in the vicinity of the interface between the gate insulating film 3 and the semiconductor substrate 1. As a result, the number of the dangling bonds and the broken bonds, which can work as the trap sites, can be actually decreased, so that the formation of the traps resulting from the application of an FN tunnel current can be suppressed. In addition, the introduced nitrogen atoms also have an effect to suppress an impurity doped in the gate electrode 4 from diffusing into the semiconductor substrate 1.

However, semiconductor integrated circuit devices have been rapidly developed to have more refinement and higher integration, the gate insulating film used in the MIS structure is becoming thinner to a thickness smaller than 10 nm. Therefore, the gate insulating film used in the conventional MIS structure is disadvantageous in the suppression of the formation of the traps resulting from the application of an FN tunnel current and the suppression of the diffusion of an impurity included in the gate electrode into the semiconductor substrate.

### SUMMARY OF THE INVENTION

In view of the aforementioned conventional problems, the first object of the invention is, in a semiconductor device having the MIS structure including a thin insulating film, suppressing formation of traps resulting from application of an FN tunnel current, and the second object is suppressing an impurity included in a conductive film formed on the insulating film from diffusing into a semiconductor layer.

In order to achieve these objects, according to the invention, a peak point in a concentration distribution of nitrogen atoms included in the insulating film is specified, and a concentration of the nitrogen atoms at the peak point in the concentration distribution of the nitrogen atoms included in the insulating film is also specified.

The first semiconductor device of this invention comprises a semiconductor layer, an insulating film, a conductive film formed successively in a vertical direction, and the insulating film is made from a silicon dioxide film including nitrogen atoms, and has a peak point in a concentration distribution of the nitrogen atoms in the silicon dioxide film in the vicinity of an interface close to the semiconductor layer.

In the first semiconductor device, the peak point in the concentration distribution of the nitrogen atoms is present in the silicon dioxide film in the vicinity of the interface close to the semiconductor layer, and hence, the nitrogen atoms are bonded with dangling bonds and broken bonds of silicon in the vicinity of the interface between the insulating film and the semiconductor layer. Accordingly, the formation of the traps resulting from application of an FN tunnel current can be suppressed in the vicinity of the interface between the insulating film and the semiconductor layer, resulting in definitely preventing degradation of the insulating film.

In the first semiconductor device, a concentration of the nitrogen atoms at the peak point in the concentration distribution of the nitrogen atoms is preferably 1.5 atom% or more and 5 atom% or less.

Thus, the dangling bonds and the broken bonds can be definitely terminated by the nitrogen atoms, resulting in definitely suppressing the formation of the traps in the vicinity of the interface between the insulating film and the semiconductor layer. In addition, it is possible to prevent excessive nitrogen atoms making no contribution to the termination of the dangling bonds and the broken bonds from working as a positive fixed charge to increase a shift of a flat-band voltage of a capacitor or a threshold voltage of a transistor.

The second semiconductor device of this invention comprises a semiconductor layer, an insulating film and a conductive film formed successively in a vertical direction, and the insulating film is made from a silicon dioxide film including nitrogen atoms, and has a first peak point in a concentration distribution of the nitrogen atoms in the silicon dioxide film in the vicinity of an interface close to the semiconductor layer and a second peak point in the concentration distribution of the nitrogen atoms in the silicon dioxide film in the vicinity of an interface close to the conductive film.

In the second semiconductor device, the first peak point in the concentration distribution of the nitrogen atoms is present in the silicon dioxide film in the vicinity of the interface close to the semiconductor layer, and the second peak point in the concentration distribution of the nitrogen atoms is present in the silicon dioxide film in the vicinity of the interface close to the conductive film. Accordingly, the nitrogen atoms are bonded with the dangling bonds and the broken bonds of silicon in the vicinity of the interfaces between the insulating film and the semiconductor layer and between the insulating film and the conductive film. As a result, the formation of the traps resulting from application of an FN tunnel current can be suppressed in the vicinity of the interfaces between the insulating film and the semiconductor layer and between the insulating film and the conductive film, resulting in definitely preventing the degradation of the insulating film in its insulating property. Furthermore, the nitrogen atoms included in the insulating film twice prevent an impurity such as boron introduced into the conductive film from diffusing from the conductive film through the insulating film into the semiconductor layer, resulting in definitely suppressing variation of a device characteristic.

In the second semiconductor device, concentrations of the nitrogen atoms at the first and second peak points in the concentration distribution of the nitrogen atoms are preferably 1.5 atom% or more and 5 atom% or less.

Thus, the nitrogen atoms can definitely terminate the dangling bonds and the broken bonds, and hence, the formation of the traps can be definitely suppressed in the vicinity of the interface between the insulating film and the semiconductor layer. In addition, it is possible to prevent excessive nitrogen atoms making no contribution to the termination of the dangling bonds and the broken bonds from working as a positive fixed charge to increase a shift of a flat-band voltage of a capacitor or a threshold voltage of a transistor.

In the second semiconductor device, a lowest concentration of the nitrogen atoms between the first peak point and the second peak point is preferably 0.1 atom% or more.

Thus, in the entire insulating layer, the nitrogen atoms can definitely terminate the dangling bonds and the broken bonds, and an impurity such as boron introduced into the conductive film can be prevented from diffusing from the conductive film through the insulating film into the semiconductor layer.

In the first method, of this invention, of manufacturing a semiconductor device including a semiconductor layer, an insulating film and a conductive film formed successively in a vertical direction, a step of forming the insulating film includes an oxide film forming step of forming a silicon dioxide film on the semiconductor layer, and a nitrided oxide film forming step of changing the silicon dioxide film into a nitrided oxide film by conducting a heating process on the silicon dioxide film in an oxidation atmosphere including nitrogen atoms.

In the step of forming the insulating film in the first method of manufacturing a semiconductor device, the silicon dioxide film formed on the semiconductor layer is treated in an oxidation atmosphere including nitrogen atoms, so as to change the silicon dioxide film into the nitrided oxide film. Therefore, the peak point in the concentration distribution of the nitrogen atoms can be definitely set in the silicon dioxide film in the vicinity of the interface close to the semiconductor layer. Accordingly, the first semiconductor device, in which the formation of the traps can be suppressed in the vicinity of the interface between the insulating film and the semiconductor layer, can be manufactured through the first method.

In the second method, of this invention, of manufacturing a semiconductor device including a semiconductor layer, an insulating film and a conductive film formed successively in a vertical direction, a step of forming the insulating film includes a nitrided oxide film forming step of growing a nitrided oxide film of silicon on the semiconductor layer by conducting a heating process on the semiconductor layer in an oxidation atmosphere including nitrogen atoms.

In the second method of manufacturing a semiconductor device, the semiconductor layer is treated in an oxidation atmosphere including nitrogen atoms, so as to grow the nitrided oxide film of silicon on the semiconductor layer. Therefore, the peak point in the concentration distribution of the nitrogen atoms can be definitely set in the silicon dioxide film in the vicinity of the interface close to the semiconductor layer. Accordingly, the first semiconductor device, in which the formation of the traps can be suppressed in the vicinity of the interface between the insulating film and the semiconductor layer, can be definitely manufactured through the second method.

In the first or second method of manufacturing a semiconductor device, the oxidation atmosphere including nitrogen atoms adopted in the nitrided oxide film forming step is preferably an atmosphere of a N₂O gas or a mixed gas including a NO gas and an O₂ gas.

Thus, nitridation with a NO gas generated through decomposition of the N₂O gas or included in the mixed gas and oxidation with an O₂ gas generated through the decomposition of the N₂O gas or included in the mixed gas can be simultaneously effected, resulting in definitely growing the nitrided oxide film of silicon.

In the first or second method of manufacturing a semiconductor device, the heating process conducted in the nitrided oxide film forming step is preferably carried out at a high pressure.

Thus, the amount of the nitrogen atoms included in the silicon dioxide film can be definitely increased.

In the first or second method of manufacturing a semiconductor device, the step of forming the insulating film preferably includes a step of nitriding the nitrided oxide film of silicon by conducting a rapid thermal process on the nitrided oxide film of silicon in an atmosphere of a NO gas or a N₂O gas.

Thus, the peak points in the concentration distribution of the nitrogen atoms can be set in the silicon dioxide film in the vicinity of the interface close to the semiconductor layer as well as that close to the conductive film. Accordingly, the formation of the traps can be suppressed in the vicinity of the interfaces between the insulating film and the semiconductor layer and between the insulating film and the conductive film. In addition, an impurity such as boron introduced into the conductive film can be twice prevented from diffusing from the conductive film through the insulating film into the semiconductor layer. As a result, the second semiconductor device can be definitely manufactured.

### BRIEF DESCRIPTION OF THE DRAWINGS

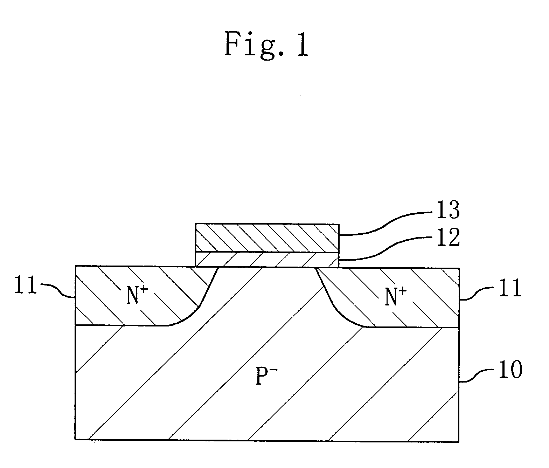

Figure 1 is a sectional view of a semiconductor device commonly described in respective embodiments of the invention;

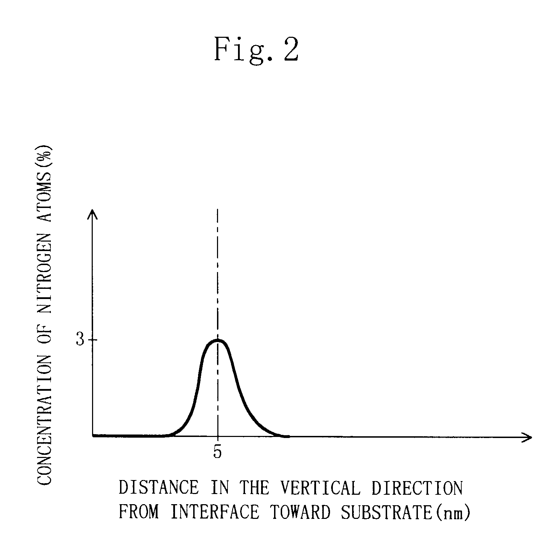

Figure 2 shows a nitrogen concentration distribution in a gate insulating film of a semiconductor device according to a first embodiment of the invention;

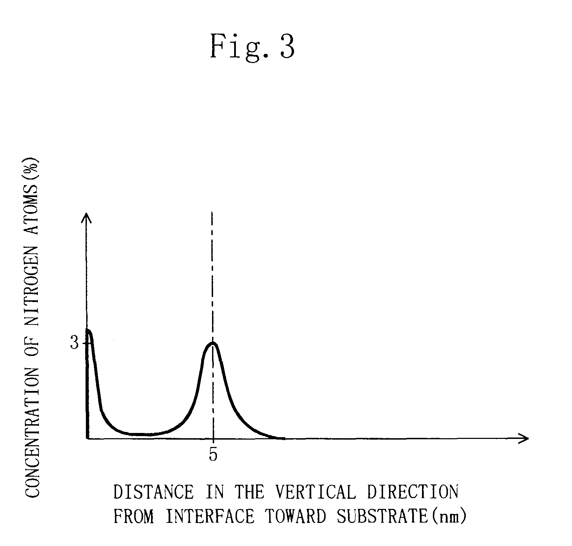

Figure 3 shows a nitrogen concentration distribution in a gate insulating film of a semiconductor device according to a second embodiment of the invention;

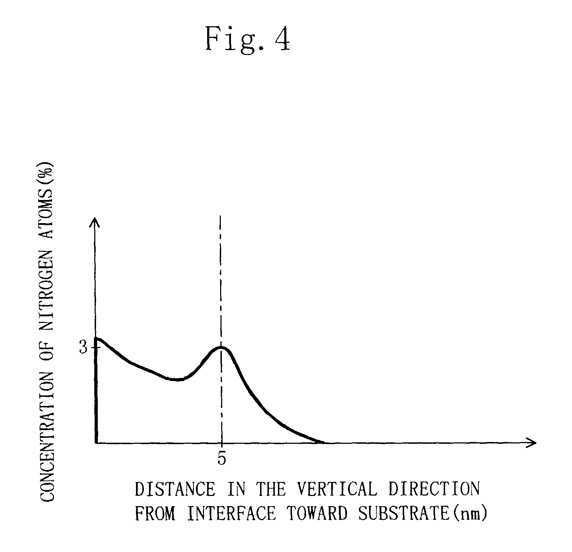

Figure 4 shows a nitrogen concentration distribution in a gate insulating film of a semiconductor device according to a third embodiment of the invention;

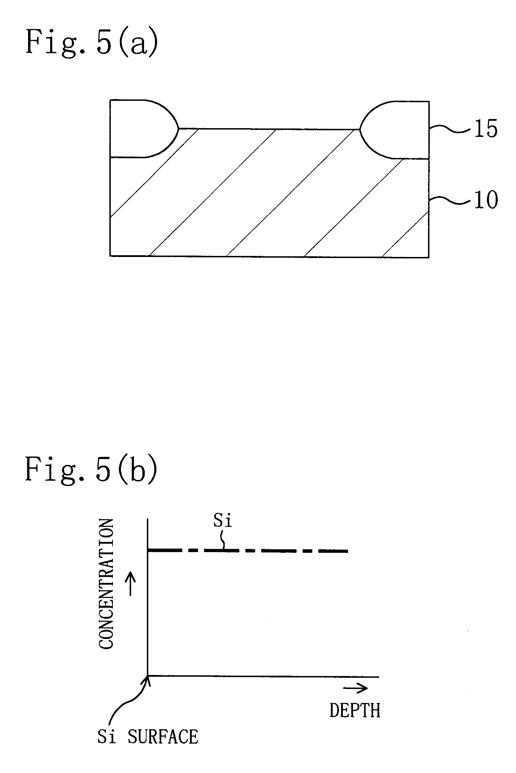

Figure 5(a) is a sectional view for showing an isolation region forming procedure in a manufacturing method according to a fourth or fifth embodiment of the invention, and Figure 5(b) is a diagram for showing a concentration profile of silicon atoms included in a semiconductor substrate in which an isolation region has been formed in the fourth embodiment;

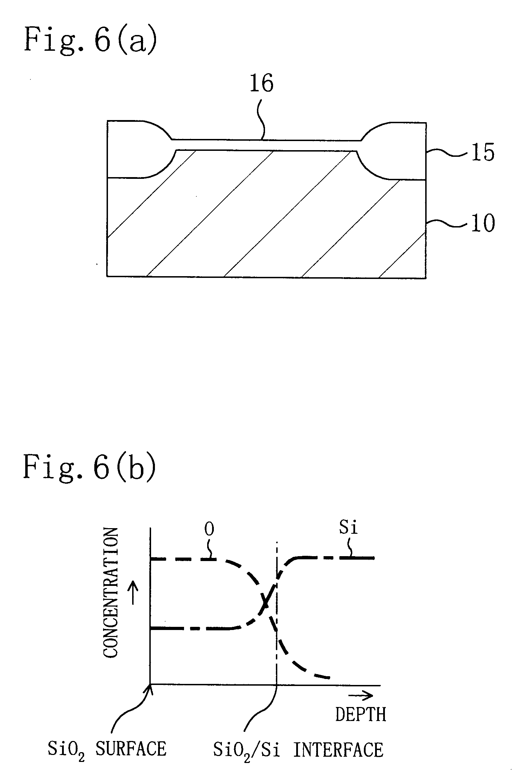

Figure 6(a) is a sectional view for showing a silicon dioxide film forming procedure in the manufacturing method of the fourth or fifth embodiment, and Figure 6(b) is a diagram for showing a concentration profile of silicon atoms and oxygen atoms included in the semiconductor substrate in which a silicon dioxide film has been formed in the fourth embodiment;

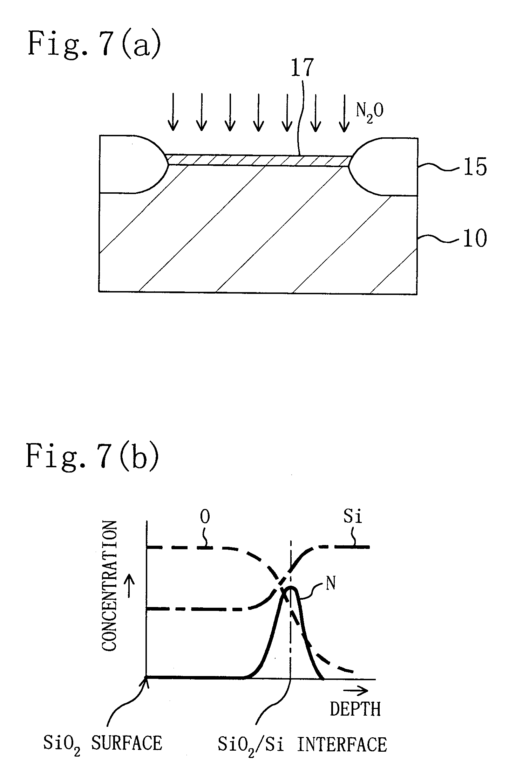

Figure 7(a) is a sectional view for showing a nitrided oxide film forming procedure in the manufacturing method of the fourth or the fifth embodiment, and Figure 7(b) is a diagram for showing a concentration profile of silicon atoms, oxygen atoms and nitrogen atoms included in the insulating film and the semiconductor substrate in which a nitrided oxide film has been formed in the fourth embodiment;

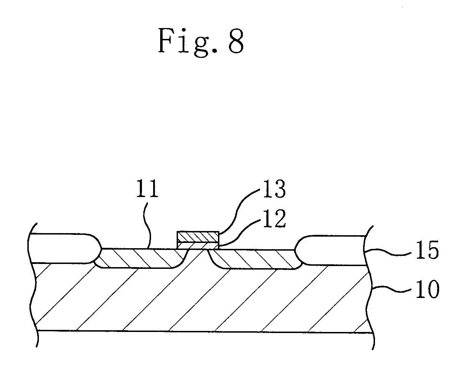

Figure 8 is a sectional view for showing a gate electrode forming procedure in the manufacturing method of the fourth or fifth embodiment;

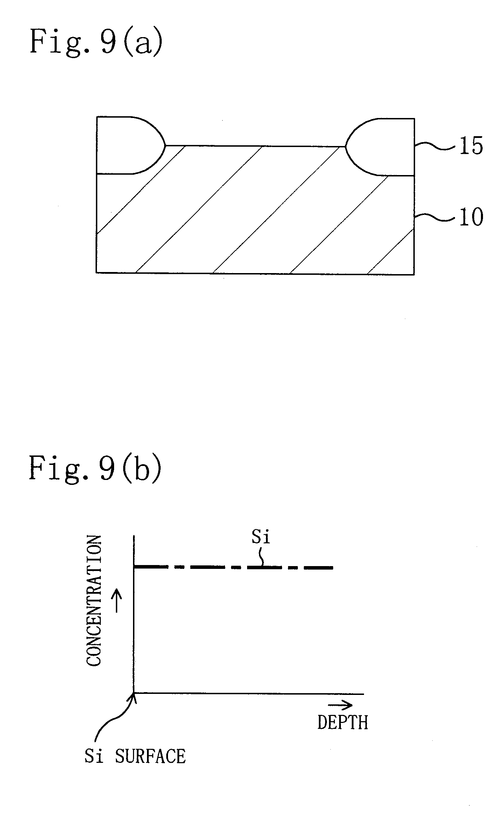

Figure 9(a) is a sectional view for showing an isolation region forming procedure in a manufacturing method according to a sixth or seventh embodiment of the invention, and Figure 9(b) is a diagram for showing a concentration profile of silicon atoms included in a semiconductor substrate in which an isolation region has been formed in the sixth embodiment;

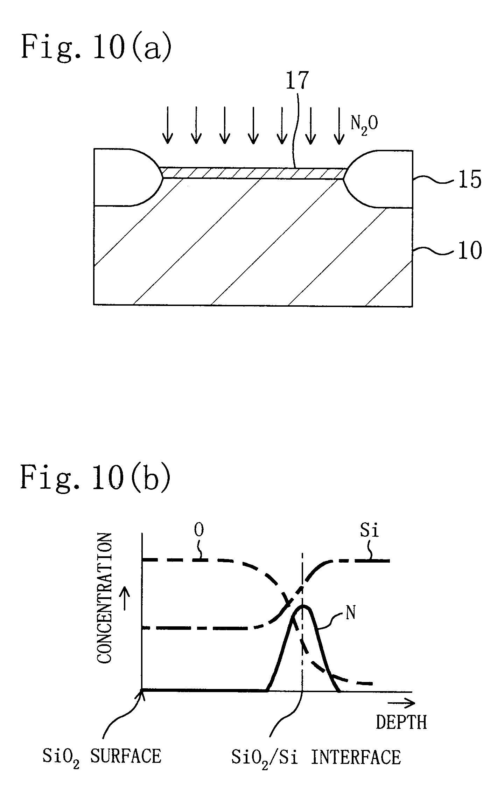

Figure 10(a) is a sectional view for showing a nitrided oxide film forming procedure in the manufacturing method of the sixth or seventh embodiment, and Figure 10(b) is a diagram for showing a concentration profile of silicon atoms, oxygen atoms and nitrogen atoms included in the insulating film and the semiconductor substrate in which a nitrided oxide film has been formed in the sixth embodiment;

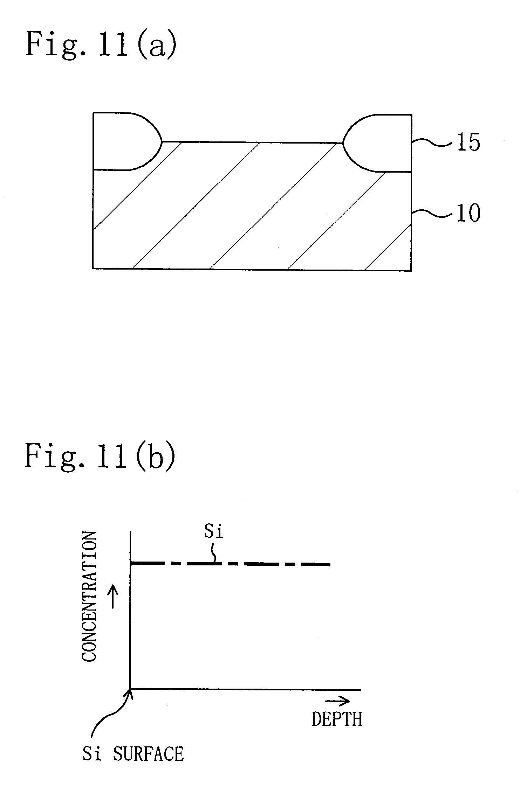

Figure 11(a) is a sectional view for showing an isolation region forming procedure in a manufacturing method according to an eighth embodiment of the invention, and Figure 11(b) is a diagram for showing a concentration profile of silicon atoms included in a semiconductor substrate in which an isolation region has been formed in the eighth embodiment;

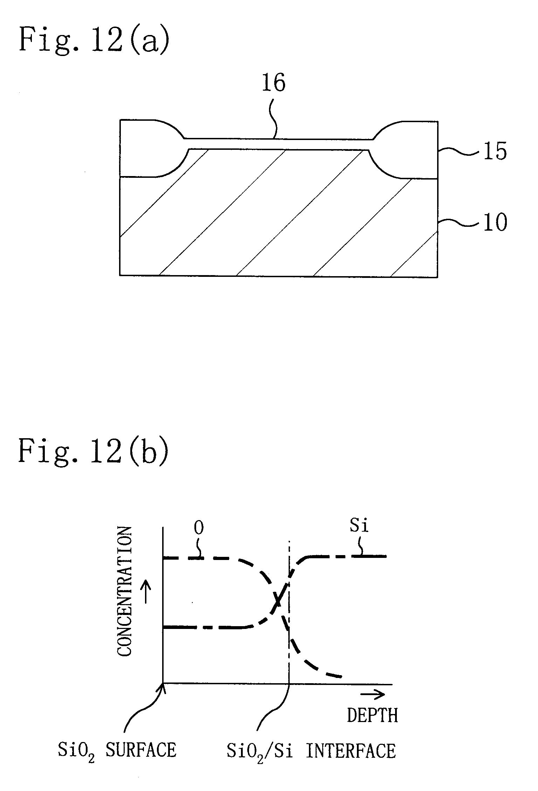

Figure 12(a) is a sectional view for showing a silicon dioxide film forming procedure in the manufacturing method of the eighth embodiment, and Figure 12(b) is a diagram for showing a concentration profile of silicon atoms and oxygen atoms included in the semiconductor substrate in which a silicon dioxide film has been formed in the eighth embodiment;

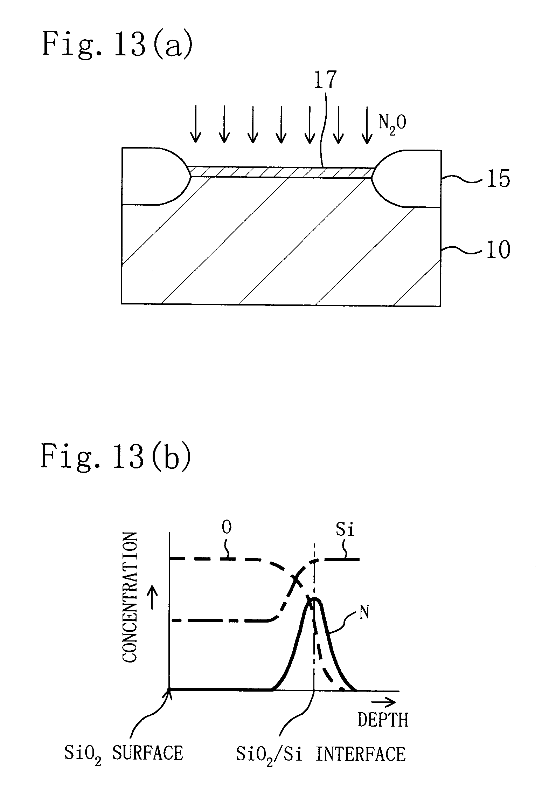

Figure 13(a) is a sectional view for showing a prior nitrided oxide film forming procedure in the manufacturing method of the eighth embodiment, and Figure 13(b) is a diagram for showing a concentration profile of silicon atoms, oxygen atoms and nitrogen atoms included in the insulating film and the semiconductor substrate in which a prior nitrided oxide film has been formed in the eighth embodiment;

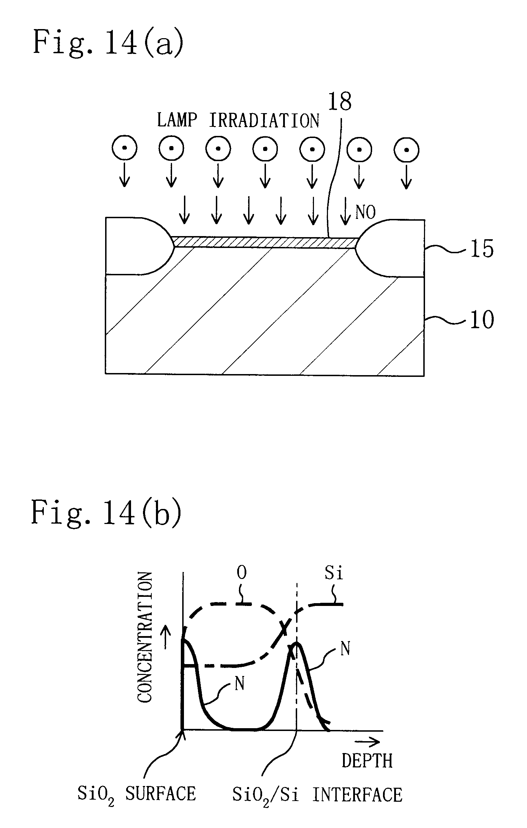

Figure 14(a) is a sectional view for showing an ultimate nitrided oxide film forming procedure in the manufacturing method of the eighth embodiment, and Figure 14(b) is a diagram for showing a concentration profile of silicon atoms, oxygen atoms and nitrogen atoms included in insulating film and the semiconductor substrate in which an ultimate nitrided oxide film has been formed in the eighth embodiment;

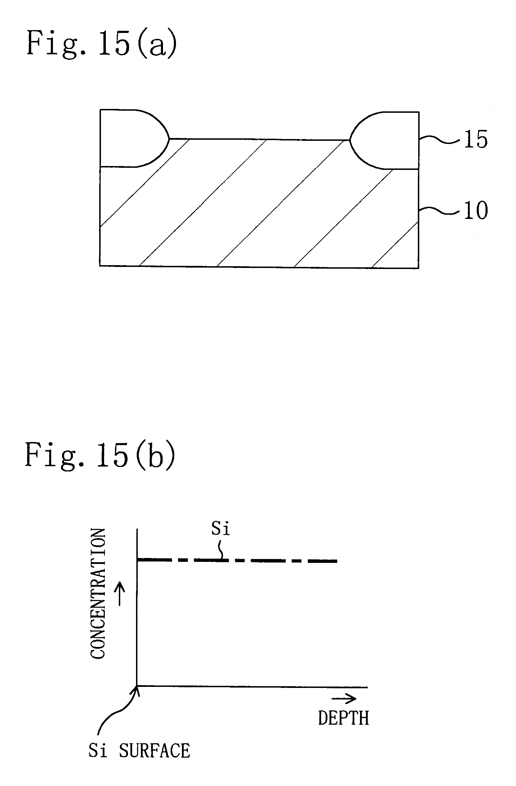

Figure 15(a) is a sectional view for showing an isolation region forming procedure in a manufacturing method according to a ninth embodiment, and Figure 15(b) is a diagram for showing a concentration profile of silicon atoms included in a semiconductor substrate in which an isolation region has been formed in the ninth embodiment;

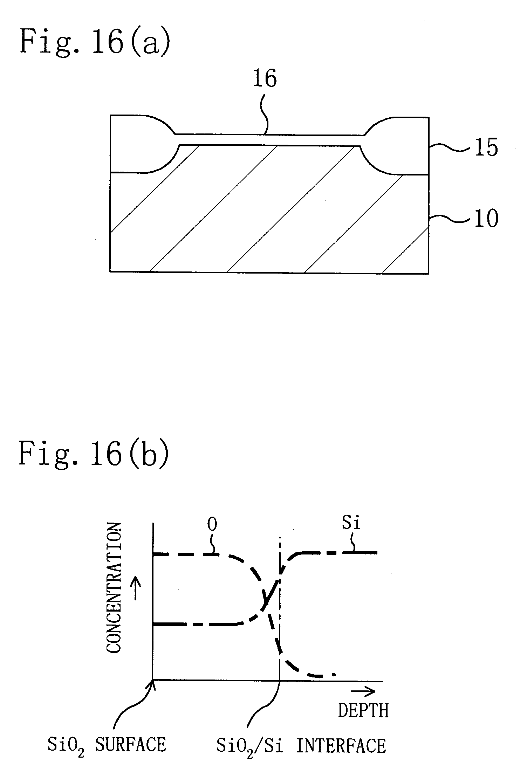

Figure 16(a) is a sectional view for showing a silicon dioxide film forming procedure in the manufacturing method of the ninth embodiment, and Figure 16(b) is a diagram for showing a concentration profile of silicon atoms and oxygen atoms included in the semiconductor substrate in which a silicon dioxide film has been formed in the ninth embodiment;

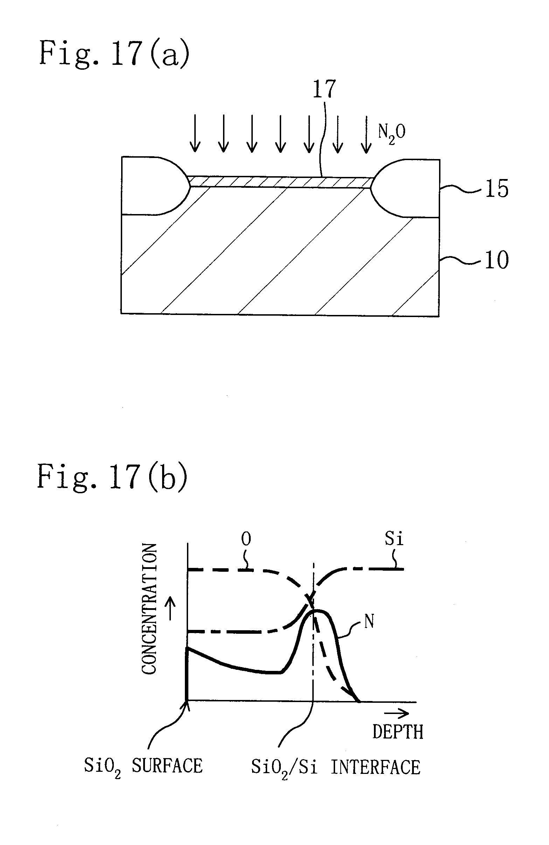

Figure 17(a) is a sectional view for showing a prior nitrided oxide film forming procedure in the manufacturing method of the ninth embodiment, and Figure 17(b) is a diagram for showing a concentration profile of silicon atoms, oxygen atoms and nitrogen atoms included in the insulating film and the semiconductor substrate in which a prior nitrided oxide film has been formed in the ninth embodiment;

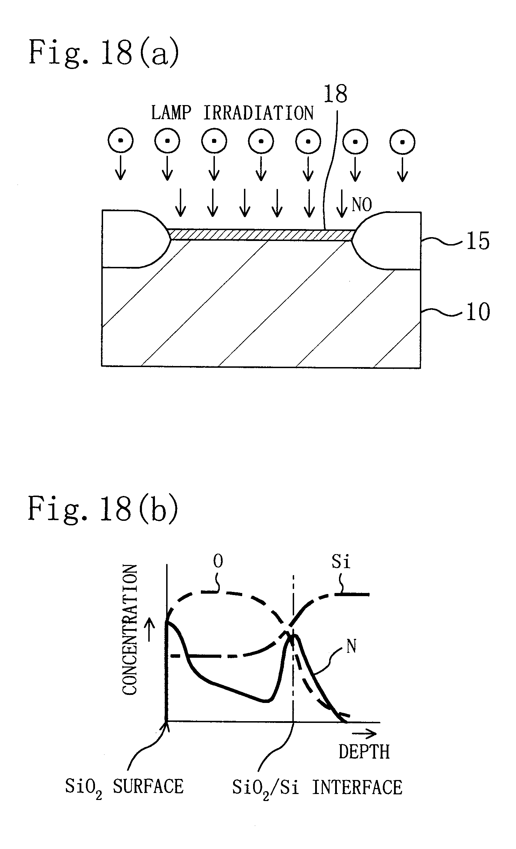

Figure 18(a) is a sectional view for showing an ultimate nitrided oxide film forming procedure in the manufacturing method of the ninth embodiment, and Figure 18(b) is a diagram for showing a concentration profile of silicon atoms, oxygen atoms and nitrogen atoms included in the insulating film and the semiconductor substrate in which an ultimate nitrided oxide film has been formed in the ninth embodiment; and
Figure 19 is a sectional view of a conventional semiconductor device.

### DETAILED DESCRIPTION OF THE INVENTION

First, a sectional structure common to all semiconductor devices according to respective embodiments of the invention will be described with reference to Figure 1.

As is shown in Figure 1, in a semiconductor substrate 10 of P⁻ type silicon, N⁺ type high concentration impurity regions 11 serving as source/drain are formed with a predetermined distance therebetween. Between the high concentration impurity regions 11 on the semiconductor substrate 10, a gate insulating film 12 made from a nitrided silicon oxide film and having a thickness of, for example, 5 nm is formed. On the gate insulating film 12, a gate electrode 13 made from polycrystalline silicon doped with an impurity, such as boron, of a high concentration is formed.

### (Embodiment 1)

Now, a concentration profile of nitrogen in the gate insulating film 12 of a semiconductor device according to a first embodiment will be described. In the first embodiment, the first object, that is, the suppression of the formation of traps resulting from application of an FN tunnel current, is achieved.

Figure 2 shows the concentration profile of nitrogen atoms in the gate insulating film 12 of this embodiment. In Figure 2, the abscissa indicates a distance in the vertical direction from an interface between the gate insulating film 12 and the gate electrode 13 toward the semiconductor substrate 10, and the ordinate indicates the concentration of the nitrogen atoms included in the gate insulating film 12 and the semiconductor substrate 10.

As is shown in Figure 2, in this embodiment, a peak point in the concentration profile of the nitrogen atoms is present in the gate insulating film 12 in the vicinity of its interface close to the semiconductor substrate 10, and the concentration of the nitrogen atoms at this peak point is approximately 3 atom%.

Since the peak point in the concentration profile of the nitrogen atoms is present in the gate insulating film 12 in the vicinity of the interface close to the semiconductor substrate 10, the nitrogen atoms are bonded with dangling bonds and broken bonds of silicon in the vicinity of the interface between the gate insulating film 12 and the semiconductor substrate 10. As a result, the formation of the traps in the vicinity of the interface between the gate insulating film 12 and the semiconductor substrate 10 can be suppressed.

The concentration of the nitrogen atoms at the peak point in the concentration profile of the nitrogen atoms is approximately 3 atom% in this embodiment, and is preferably in the range between 1.5 atom% and 5 atom%. The reason is as follows: The effect to decrease the number of dangling bonds and broken bonds by introducing nitrogen atoms is brought because the dangling bonds and the broken bonds are terminated by the nitrogen atoms. When the peak value in the concentration profile of the nitrogen atoms exceeds 1.5 atom%, the dangling bonds and the broken bonds in the vicinity of the interface between the gate insulating film 12 and the semiconductor substrate 10 can be completely terminated by the introduced nitrogen atoms. In other words, when the peak value in the concentration profile of the nitrogen atoms is lower than 1.5 atom%, the dangling bonds and the broken bonds cannot be sufficiently terminated, and hence, the effect in improvement of the traps in the vicinity of the interface between the gate insulating film 12 and the semiconductor substrate 10 cannot be sufficiently exhibited.

On the other hand, when the concentration of the nitrogen atoms exceeds 5 atom%, although the dangling bonds and the broken bonds in the vicinity of the interface between the gate insulating film 12 and the semiconductor substrate 10 can be completely terminated, there remain excessive nitrogen atoms, namely, nitrogen atoms making no contribution to the termination of the dangling bonds and the broken bonds. Such excessive nitrogen atoms making no contribution to the termination function as a positive fixed charge, resulting in increasing a shift of a flat-band voltage of a capacitor or a threshold voltage of a transistor.

In order to suppress an impurity such as boron introduced into the gate electrode 13 from diffusing into the semiconductor substrate 10, a higher peak value in the concentration profile of the nitrogen atoms is preferred, but when the concentration of the nitrogen atoms exceeds 5 atom%, the aforementioned problem newly occurs.

For the aforementioned reasons, the peak point in the concentration profile of the nitrogen atoms is set in the gate insulating film 12 in the vicinity of the interface close to the semiconductor substrate 10, and the concentration of the nitrogen atoms at the peak point in the concentration profile of the nitrogen atoms is set in the range between 1.5 atom% and 5 atom% in this embodiment.

### (Embodiment 2)

Now, a concentration profile of nitrogen in the gate insulating film 12 of a semiconductor device according to a second embodiment of the invention will be described. In the second embodiment, the first object, that is, the suppression of the formation of the traps resulting from the application of an FN tunnel current, and the second object, that is, the suppression of diffusion of an impurity included in the gate electrode 12 into the semiconductor substrate 10, are both achieved.

Figure 3 shows the concentration profile of nitrogen atoms in the gate insulating film 12 of this embodiment. In Figure 3, the abscissa indicates a distance in the vertical direction from the interface between the gate insulating film 12 and the gate electrode 13 toward the semiconductor substrate 10, and the ordinate indicates the concentration of the nitrogen atoms included in the gate insulating film 12 and the semiconductor substrate 10.

As is shown in Figure 3, in the second embodiment, the peak points in the concentration profile of the nitrogen atoms are present in the gate insulating film 12 in the vicinity of the interface close to the semiconductor substrate 10 and in the vicinity of the interface close to the gate electrode 13, and the concentrations of the nitrogen atoms at these peak points in the concentration profile are both approximately 3 atom%.

Since the peak points in the concentration profile of the nitrogen atoms are in the gate insulating film 12 in the vicinity of the interface close to the semiconductor substrate 10 and that close to the gate electrode 13, the nitrogen atoms are bonded with the dangling bonds and the broken bonds in the vicinity of the interface between the gate insulating film 12 and the semiconductor substrate 10 and the interface between the gate insulating film 12 and the gate electrode 13. Therefore, the formation of the traps are suppressed in the vicinity of the interface between the gate insulating film 12 and the semiconductor substrate 10 and the interface between the gate insulating film 12 and the gate electrode 13.

Furthermore, the concentrations of the nitrogen atoms at the peak points in the concentration profile of the nitrogen atoms are both approximately 3 atom% in this embodiment, and the peak values in the concentration profile of the nitrogen atoms in the gate insulating film 12 in the vicinity of the interface close to the semiconductor substrate 10 and that close to the gate electrode 13 are preferably in the range between 1.5 atom% and 5 atom% for the same reasons as described in the first embodiment.

Also, since the peak points in the concentration profile of the nitrogen atoms in the gate insulating film 12 are present in the gate insulating film 12 in the vicinity of the interface close to the semiconductor substrate 10 as well as in the vicinity of the interface close to the gate electrode 13 in the second embodiment, the nitrogen atoms introduced into the gate insulating film 12 twice prevent an impurity such as boron from diffusing from the gate electrode 13 through the gate insulating film 12 into the semiconductor substrate 10. Thus, variation of electrical characteristics such as threshold voltage, hot carrier immunity and gate insulator dielectric reliability can be definitely prevented.

In this manner, in the second embodiment, the peak points in the concentration profile of the nitrogen atoms are set in the gate insulating film 12 in the vicinity of the interface close to the semiconductor substrate 10 as well as in the vicinity of the interface close to the gate electrode 13, and the concentrations of the nitrogen atoms at the peak points in the concentration profile are set in the range between 1.5 atom% and 5 atom%. Accordingly, excessive nitrogen atoms making no contribution to the termination of the dangling bonds and the broken bonds can be prevented from working as a positive fixed charge so as to increase the shift of the flat-band voltage of a capacitor or the threshold voltage of a transistor, and the formation of the traps resulting from the application of an FN tunnel current and the diffusion of an impurity included in the gate electrode 13 into the semiconductor substrate 10 can be more definitely suppressed.

### (Embodiment 3)

Now, a concentration profile of nitrogen in the gate insulating film 12 of a semiconductor device according to a third embodiment of the invention will be described. In the third embodiment, the first object, that is, the suppression of the formation of the traps resulting from the application of an FN tunnel current, and the second object, that is, the suppression of the diffusion of an impurity included in the gate electrode 13 into the semiconductor substrate 10, are both achieved.

Figure 4 shows the concentration profile of nitrogen atoms in the gate insulating film 12 of the third embodiment. In Figure 4, the abscissa indicates a distance in the vertical direction from the interface between the gate insulating film 12 and the gate electrode 13 toward the semiconductor substrate 10, and the ordinate indicates the concentration of the nitrogen atoms included in the gate insulating film 12 and the semiconductor substrate 10.

As is shown in Figure 4, in the third embodiment, the peak points in the concentration profile of the nitrogen atoms are present in the gate insulating film 12 in the vicinity of the interface close to the semiconductor substrate 10 and in the vicinity of the interface close to the gate electrode 13. The concentrations of the nitrogen atoms at these peak points are both approximately 3 atom%, and a lowest concentration of the nitrogen atoms between the peak points is approximately 1 atom%

Also in the third embodiment, the peak values in the concentration profile of the nitrogen atoms in the gate insulating film 12 in the vicinity of the interface close to the semiconductor substrate 10 and that close to the gate electrode 13 are preferably in the range between 1.5 atom% and 5 atom% for the same reasons as described in the first embodiment.

In Figure 4, the lowest concentration of the nitrogen atoms between the peak points in the concentration profile is approximately 1 atom%, and the lowest concentration of the nitrogen atoms is preferably in the range between 0.1 atom% and 3 atom%. When the lowest concentration is within this range, the nitrogen atoms are bonded with the dangling bonds and the broken bonds in the entire region of the gate insulating film 12, and hence, the formation of the traps can be further suppressed. In addition, an impurity such as boron can be prevented from diffusing from the gate electrode 13 through the gate insulating film 12 into the semiconductor substrate 10 in the entire region of the gate insulating film 12, and hence, the variation in the characteristic of the resultant device can be more definitely suppressed.

When the entire gate insulating film 12 is divided into substantially three portions having the same thickness in the vertical direction, namely, into a shallow region close to the gate electrode 13, a deep region close to the semiconductor substrate 10 and an intermediate region between the shallow region and the deep region, the intermediate region includes relatively low density of dangling bonds and broken bonds as compared with the shallow region and the deep region. Therefore, the concentration of the nitrogen atoms in the intermediate region can be lower than that in the shallow region and the deep region.

In this manner, in the third embodiment, the peak points in the concentration profile of the nitrogen atoms are set in the gate insulating film 12 in the vicinity of the interface close to the semiconductor substrate 10 and in the vicinity of the interface close to the gate electrode 13, the concentration of the nitrogen atoms at these peak points in the concentration profile are set within the range between 1.5 atom% and 5 atom%, and the lowest concentration of the nitrogen atoms between the peak points is set within the range between 0.1 atom% and 3 atom%. Accordingly, excessive nitrogen atoms making no contribution to the termination of the dangling bonds and the broken bonds can be prevented from working as a positive fixed charge so as to increase the shift of the flat-band voltage of a capacitor or the threshold voltage of a transistor, and the formation of the traps resulting from the application of an FN tunnel current and the diffusion of an impurity included in the gate electrode 13 into the semiconductor substrate 10 can be more definitely suppressed.

### (Embodiment 4)

In a fourth embodiment of the invention, a method of manufacturing the semiconductor device of the first embodiment will be described with reference to Figures 5 through 8.

First, as is shown in Figure 5(a), after forming an isolation region (LOCOS oxide film) 15 in the P⁻ type semiconductor substrate 10 of silicon, an active area surrounded with the isolation region 15 on the surface of the semiconductor substrate 10 is cleaned, so as to remove an undesirable impurity and a natural oxide film thereon. Figure 5(b) shows a concentration profile of silicon atoms included in the semiconductor substrate 10 in which the isolation region 15 has been formed, wherein the abscissa indicates a distance in the vertical direction from the surface of the semiconductor substrate 10.

Next, as is shown in Figure 6(a), the semiconductor substrate 10 is subjected to the pyrogenic oxidation at a temperature of 850° in an oxidation atmosphere by using, for example, an atmospheric electric furnace, thereby forming a silicon dioxide film 16 with a thickness of 4 nm working as a base. Figure 6(b) shows a concentration profile of silicon atoms and oxygen atoms included in the semiconductor substrate 10 in which the silicon dioxide film 16 has been formed, wherein the interface between the silicon dioxide film 16 and the semiconductor substrate 10 is shown with a dashed line.

Then, as is shown in Figure 7(a), the semiconductor substrate 10 is subjected to a nitriding oxidation process at a temperature of 800 through 1150°C in an oxidation atmosphere including nitrogen (for example, an atmosphere including a N₂O gas or a NO gas), thereby forming a nitrided oxide film 17 with a thickness of 5 nm.

Figure 7(b) shows a concentration profile of silicon atoms, oxygen atoms and nitrogen atoms included in the insulating film and the semiconductor substrate 10 which has been subjected to the nitriding oxidation process at a temperature of 1050°C in an atmosphere of a N₂O gas by using an atmospheric electric furnace. In the fourth embodiment, after forming the silicon dioxide film 16 with a thickness of 4 nm working as a base, the nitriding oxidation process is conducted so as to form the nitrided oxide film 17 with a thickness of 5 nm. Therefore, the peak point in the concentration profile of the nitrogen atoms can be set in the gate insulating film 12 in the vicinity of the interface close to the semiconductor substrate 10. Specifically, as is shown in Figure 7(b), the peak point in the concentration profile of the nitrogen atoms is present in the gate insulating film 12 in the vicinity of the interface close to the semiconductor substrate 10, and the concentration of the nitrogen atoms at the peak point in the concentration profile is approximately 2 atom%.

The nitriding oxidation process using a N₂O gas has a disadvantage that a low film growth rate results in poor uniformity in the film thickness. However, as in the fourth embodiment, when the nitriding oxidation process using a N₂O gas is conducted after forming the silicon dioxide film 16 working as a base, the thickness of the film to be formed through the nitriding oxidation process is so small that the disadvantage of the low film forming speed can be compensated, resulting in shortening of growth time as well as improving the uniformity in the thickness of the nitrided oxide film 17. The reason is considered as follows: In the nitriding oxidation process using a N₂O gas, the N₂O gas is decomposed into NO, N₂ and O₂ at a high temperature, so that the nitrided oxide film 17 is formed while oxidation with an O₂ gas and nitridation with a NO gas are being simultaneously effected. Therefore, the uniformity in the thickness of the nitrided oxide film 17 can be improved.

Next, as is shown in Figure 8, the gate electrode 13 is formed on the gate insulating film 12 made of the nitrided oxide film 17, and an N type impurity is implanted by using the gate electrode 13 as a mask, thereby forming the N⁺ type high concentration impurity regions 11 working as the source/drain. Thus, the semiconductor device of the first embodiment is manufactured.

In this manner, in the fourth embodiment, since the peak point in the concentration profile of the nitrogen atoms can be set in the gate insulating film 12 in the vicinity of the interface close to the semiconductor substrate 10, the dangling bonds and the broken bonds present in the vicinity of the interface between the gate insulating film 12 and the semiconductor substrate 10 can be definitely terminated by the nitrogen atoms, resulting in improving the trap characteristic.

Furthermore, the amount of the nitrogen atoms introduced into the gate insulating film 12 in the vicinity of the interface close to the semiconductor substrate 10 is substantially in proportion to the film thickness increase brought through the nitriding oxidation process. Therefore, the concentration of the nitrogen atoms in the vicinity of the interface can be easily controlled. For example, in the case where the thickness of the nitrided oxide film formed through the nitriding oxidation process is previously determined, a ratio between the thickness of the silicon dioxide film working as a base and the thickness of the nitrided oxide film increased through the nitriding oxidation process is controlled, so that the amount of the nitrogen atoms introduced into the interface can be controlled to some extent. Moreover, since the concentration of the nitrogen atoms on the interface is not sensitive to the conditions for the nitriding oxidation process such as a temperature, the conditions for the nitriding oxidation process can be determined with thermal budget (heat history, i.e., the products of process time and process temperature) taken into consideration.

When the process for forming the silicon dioxide film 16 working as a base through the oxidation and the process for forming the nitrided oxide film 17 through the nitriding oxidation process are continuously conducted in the same electric furnace, metal contamination and adhesion of particles can be avoided from occurring between the oxidation and the nitriding oxidation process, and the productivity of the nitrided oxide film forming process can be improved. For example, when a sequence of the nitriding oxidation process is added to a sequence of forming the silicon dioxide film in the electric furnace, these two processes can be carried out with ease.

### (Embodiment 5)

In a fifth embodiment of the invention, another method of manufacturing the semiconductor device of the first embodiment will be described with reference to Figures 5 through 8.

First, as is shown in Figure 5(a), an isolation region 15 is formed in the P⁻ type semiconductor substrate 10 of silicon, and an active area surrounded with the isolation region 15 on the surface of the semiconductor substrate 10 is cleaned, so as to remove an impurity and a natural oxide film thereon.

Then, as is shown in Figure 6(a), the semiconductor substrate 10 is subjected to the dry oxidation in an oxidation atmosphere using, for example, a high-pressure electric furnace, thereby forming a silicon dioxide film 16 with a thickness of 4 nm serving as a base.

Next, as is shown in Figure 7(a), the semiconductor substrate 10 is subjected to a nitriding oxidation process at a comparatively low temperature of 750 through 850°C at 5 or more atmospheric pressure in an oxidation atmosphere including nitrogen (for example, an atmosphere including a N₂O gas or a NO gas) by using, for example, a high-pressure electric furnace, thereby forming a nitrided oxide film 17 with a thickness of 5 nm.

In the fifth embodiment, after forming the silicon dioxide film 16 with a thickness of 4 nm working as a base, the nitriding oxidation process is conducted at a high pressure, so as to form the nitrided oxide film 17 with a thickness of 5 nm. Therefore, the peak point in the concentration profile of the nitrogen atoms can be set in the gate insulating film 12 in the vicinity of the interface close to the semiconductor substrate 10, and the concentration of the nitrogen atoms at the peak point in the concentration profile can be set at approximately 3 atom%.

Next, as is shown in Figure 8, the gate electrode 13 is formed on the gate insulating film 12 made of the nitrided oxide film 17, and an N type impurity is implanted by using the gate electrode 13 as a mask, thereby forming the N⁺ type high concentration impurity regions 11 working as the source/drain. Thus, the semiconductor substrate of the first embodiment can be manufactured.

In the fifth embodiment, since the nitriding oxidation process is conducted at a high pressure, the nitrided oxide film 17 entirely includes the nitrogen atoms at a comparatively high concentration. Therefore, the formation of the traps can be definitely suppressed, and additionally, the effect to suppress the diffusion of an impurity included in the gate electrode 13 into the semiconductor substrate 10 can be further improved as compared with that in the fourth embodiment.

The atmospheric electric furnace is used for the nitriding oxidation process in the fourth embodiment, and the high-pressure electric furnace is used for the nitriding oxidation process in the fifth embodiment. Instead, the nitrided oxide film 17 can be formed by conducting a nitriding oxidation process on the silicon dioxide film 16 working as the base in an oxidation atmosphere including nitrogen (for example, an atmosphere including a N₂O gas or a NO gas) by using an RTP (rapid thermal process) apparatus with halogen or arc-lamp heating. Alternatively, the nitrided oxide film 17 can be formed by conducting a nitriding oxidation process on the silicon dioxide film 16 working as the base in an oxidation atmosphere including nitrogen (for example, an atmosphere including a N₂O gas) by using an RTP apparatus provided with a shower head and a substrate rotating mechanism. In the latter case, the N₂O gas can be uniformly introduced, and hence, the uniformity in the thickness of the nitrided oxide film 17 can be further improved.

Furthermore, as the silicon dioxide film 16 working as the base, a thermal oxidation film by thermal oxidation using a hot wall type electric furnace or by rapid thermal oxidation using an RTP apparatus, and a deposition film by low pressure CVD can be used.

### (Embodiment 6)

In a sixth embodiment of the invention, a still another method of manufacturing the semiconductor device of the first embodiment will be described with reference to Figures 9 and 10.

First, as is shown in Figure 9(a), an isolation region 15 is formed in the P⁻ type semiconductor substrate 10 of silicon, and an active area surrounded with the isolation region 15 on the surface of the semiconductor substrate 10 is cleaned, so as to remove an impurity and a natural oxide film thereon. Figure 9(b) shows a concentration profile of silicon atoms included in the semiconductor substrate 10 in which the isolation region 15 has been formed, wherein the abscissa indicates a distance in the vertical direction from the surface of the semiconductor substrate 10.

Next, as is shown in Figure 10(a), the semiconductor substrate 10 is subjected to a nitriding oxidation process at a temperature lower than 1000°C in an oxidation atmosphere including nitrogen (for example, an atmosphere including a N₂O gas or including a mixed gas of NO and O₂) by using an RTP apparatus such as a light emitting heater, thereby forming a nitrided oxide film 17 with a thickness of 5 nm.

When the nitriding oxidation process is conducted by using a N₂O gas, the N₂O gas is decomposed into NO, N₂ and O₂ at a high temperature, and hence, the oxidation with the O₂ gas and the nitridation with the NO gas are simultaneously effected. However, since the decomposition of the N₂O gas does not rapidly proceeds, the uniformity in the thickness of the nitrided oxide film 17 is poor. Therefore, it is necessary to provide any means for uniformly introducing the N₂O gas onto the surface of the semiconductor substrate 10 in the formation of the nitrided oxide film 17. A conventional hot wall furnace with resistive heater has a disadvantage that a long processing time is required because it is difficult to uniformly introduce the N₂O gas and the oxygen nitriding reaction is difficult to proceed. Accordingly, when the N₂O gas is used, it is preferred that an RTP apparatus provided with a shower head is used as well as the semiconductor substrate 10 is provided with a rotation mechanism, so that the N₂O gas can be uniformly introduced onto the semiconductor substrate 10 and the thickness uniformity of the nitrided oxide film 17 can be improved.

In the case where the mixed gas of NO and O₂ is used for the nitriding oxidation process, the nitriding oxidation process can be conducted at a temperature lower than 1000°C by using a mixed gas including, for example, 5 vol% NO gas and 95 vol% O₂ gas. Thus, since there is no need to decompose a N₂O gas into NO, N₂ and O₂ at a high temperature, the temperature for the nitriding oxidation process can be set low and the time required for the decomposition can be omitted.

Furthermore, both in an atmosphere including a N₂O gas and in an atmosphere including a mixed gas of NO and O₂, when the nitriding oxidation process is conducted at a temperature lower than 1000°C, decrease in thermal budget can be contemplated.

Figure 10(b) shows a concentration profile of silicon atoms, oxygen atoms and nitrogen atoms included in the insulating film and the semiconductor substrate 10 in which the nitrided oxide film 17 has been formed through a nitriding oxidation process in an atmosphere including a N₂O gas by using a light emitting heater. As is shown in Figure 10(b), the peak point in the concentration profile of the nitrogen atoms can be set in the gate insulating film 12 in the vicinity of the interface close to the semiconductor substrate 10, and the concentration of the nitrogen atoms at the peak point in the concentration profile can be set at approximately 2 atom%.

Next, similarly to the fourth embodiment, the gate electrode 13 is formed on the gate insulating film 12 made of the nitrided oxide film 17, and an N type impurity is implanted by using the gate electrode 13 as a mask, thereby forming the N⁺ type high concentration impurity regions 11 working as the source/drain. Thus, the semiconductor device of the first embodiment can be manufactured.

In the sixth embodiment, since the semiconductor substrate 10 is subjected to the nitriding oxidation process in an oxidation atmosphere including nitrogen by using a RTP apparatus, the uniformity in the thickness of the nitrided oxide film 17 can be improved, and the peak point in the concentration profile of the nitrogen atoms can be definitely set in the gate insulating film 12 in the vicinity of the interface close to the semiconductor substrate 10.

### (Embodiment 7)

In a seventh embodiment of the invention, a still another method of manufacturing the semiconductor device of the first embodiment will be described with reference to Figures 9 and 10.

First, as is shown in Figure 9(a), an isolation region 15 is formed in the P⁻ type semiconductor substrate 10 of silicon, and an active area surrounded with the isolation region 15 on the surface of the semiconductor substrate 10 is cleaned, so as to remove an impurity and a natural oxide film thereon.

Next, as is shown in Figure 10(a), the semiconductor substrate 10 is subjected to a nitriding oxidation process at a comparatively low temperature of 750 through 850°C at 5 or more atmospheric pressure in an oxidation atmosphere including nitrogen (for example, an atmosphere including a N₂O gas or a mixed gas of NO and O₂) by using a high-pressure electric furnace, thereby forming a nitrided oxide film 17 with a thickness of 5 nm.

When the nitriding oxidation process is conducted by using the N₂O gas, the decomposition of the N₂O gas into NO, N₂ and O₂ is premised, and hence, such a process has a disadvantage of a low reaction speed unless the process is conducted at a high temperature. However, since the thermal budget is recently desired to be further decreased, a process carried out at a high temperature for a long period of time is difficult to adopt. Therefore, the process temperature and the process time can be decreased by conducting the nitriding oxidation process at a high pressure of approximately 25 atmospheric pressure. For example, when the process is conducted by using the N₂O gas at 25 atmospheric pressure, the nitrided oxide film 17 can be formed at a comparatively low temperature of 750 through 850°C.

Furthermore, when the nitriding oxidation process is conducted by using a mixed gas including NO and O₂, the nitriding oxidation process can be carried out at a temperature lower than 1000°C by using a mixed gas including 5 vol% NO gas and 95 vol% O₂ gas. Thus, there is no need to decompose a N₂O gas into NO, N₂ and O₂ at a high temperature, the temperature for the nitriding oxidation process can be set low, and the time for the decomposition can be omitted.

Next, similarly to the fourth embodiment, the gate electrode 13 is formed on the gate insulating film 12 made of the nitrided oxide film 17, and an N type impurity is implanted by using the gate electrode 13 as a mask, thereby forming the N⁺ type high concentration impurity regions 11 working as the source/drain. Thus, the semiconductor device of the first embodiment can be manufactured.

In the seventh embodiment, the nitrided oxide film 17 with a thickness of 5 nm is formed by conducting the nitriding oxidation process on the semiconductor substrate 10 at a high pressure, and hence, the peak point in the concentration profile of the nitrogen atoms can be set in the gate insulating film 12 in the vicinity of the interface close to the semiconductor substrate 10, and the concentration of the nitrogen atoms at the peak point in the concentration profile can be set at approximately 3 atom%.

### (Embodiment 8)

In an eighth embodiment of the invention, a method of manufacturing the semiconductor device of the second embodiment will be described with reference to Figures 11 through 14.

First, as is shown in Figure 11(a), an isolation region 15 is formed in the P⁻ type semiconductor substrate 10 of silicon, and an active area surrounded with the isolation region 15 on the surface of the semiconductor substrate 10 is cleaned, so as to remove an impurity and a natural oxide film thereon. Figure 11(b) shows a concentration profile of silicon atoms included in the semiconductor substrate 10 in which the isolation region 15 has been formed, wherein the abscissa indicates a distance in the vertical direction from the surface of the semiconductor substrate 10.

Next, as is shown in Figure 12(a), the semiconductor substrate 10 is subjected to the pyrogenic oxidation in an oxidation atmosphere through rapid thermal oxidation (RTO) using RTP apparatus, thereby forming a silicon dioxide film 16 with a thickness of 4 nm serving as a base. Figure 12(b) shows a concentration profile of silicon atoms and oxygen atoms included in the semiconductor substrate 10 in which the silicon dioxide film 16 has been formed, wherein the interface between the silicon dioxide film 16 and the semiconductor substrate 10 is shown with a dashed line.

Then, the introduced gas is changed to a laughing gas (N₂O gas) in the same chamber, so that the semiconductor substrate 10 can be subjected to a first nitriding process (RTN process) at a temperature of, for example, 1000°C for 30 seconds in an atmosphere of a laughing gas. As a result, a prior nitrided oxide film 17 with a thickness of 5 nm is formed as is shown in Figure 13(a).

Figure 13(b) shows a concentration profile of silicon atoms, oxygen atoms and nitrogen atoms included in the insulating film and the semiconductor substrate 10 in which the prior nitrided oxide film 17 has been formed. The peak point in the concentration profile of the nitrogen atoms is present in the gate insulating film 12 in the vicinity of the interface close to the semiconductor substrate 10, and the concentration of the nitrogen atoms at the peak point in the concentration profile is approximately 2 atom%.

Next, the introduced gas is changed to a nitrous oxide gas (NO gas) in the same chamber, so that the semiconductor substrate 10 can be subjected to a second nitriding process (RTN process) at a temperature of, for example, 850°C for 10 seconds in an atmosphere of a nitrous oxide gas by RTP apparatus. As a result, an ultimate nitrided oxide film 18 with a thickness of 5 nm is formed as is shown in Figure 14(a).

Figure 14(b) shows a concentration profile of silicon atoms, oxygen atoms and nitrogen atoms included in the insulating film and the semiconductor substrate 10 in which the ultimate nitrided oxide film 18 has been formed. The peak points in the concentration profile of the nitrogen atoms are present in the gate insulating film 12 not only in the vicinity of the interface close to the semiconductor substrate 10 but also in the vicinity of the interface close to the gate electrode 13, and the concentration of the nitrogen atoms at these peaks are both approximately 2 atom%.

Then, similarly to the fourth embodiment, the gate electrode 13 is formed on the gate insulating film 12 made of the nitrided oxide film 18, and an N type impurity is implanted by using the gate electrode 13 as a mask, thereby forming the N⁺ type high concentration impurity regions 11 working as the source/drain. Thus, the semiconductor device of the second embodiment can be manufactured.

In the eighth embodiment, after forming the silicon dioxide film 16 working as a base, the first nitriding process in a laughing gas and the second nitriding process in a nitrous oxide gas are carried out. Therefore, the peak points in the concentration profile of the nitrogen atoms in the gate insulating film 12 are present in the gate insulating film 12 in the vicinity of the interface close to the semiconductor substrate 10 as well as in the vicinity of the interface close to the gate electrode 13.

In the eighth embodiment, the silicon dioxide film 16 working as a base is formed by the RTO, but it goes without saying that the same effects can be attained by forming the silicon dioxide film 16 out of a conventional thermal oxide film, a deposited oxide film such as an HTO film or a TEOS film.

Also, without forming the silicon dioxide film 16 working as a base, the semiconductor substrate 10 can be directly subjected to a heating process in a laughing gas or a nitrous oxide gas. In this manner, the peak point in the concentration profile of the nitrogen atoms can be set in the gate insulating film 12 in the vicinity of the interface close to the semiconductor substrate 10.

### (Embodiment 9)

In a ninth embodiment of the invention, a method of manufacturing the semiconductor device of the third embodiment will be described with reference to Figures 15 through 18.

First, as is shown in Figure 15(a), after forming an isolation region 15 is formed in the P⁻ type semiconductor substrate 10 of silicon, an active area surrounded with the isolation region 15 on the surface of the semiconductor substrate 10 is cleaned, so as to remove an impurity and a natural oxide film thereon. Figure 15(b) shows a concentration profile of silicon atoms included in the semiconductor substrate 10 in which the isolation region 15 has been formed, wherein the abscissa indicates a distance in the vertical direction from the surface of the semiconductor substrate 10.

Next, as is shown in Figure 16(a), the semiconductor substrate 10 is subjected to the pyrogenic oxidation at a temperature of 850°C in an oxidation atmosphere by using, for example, an atmospheric electric furnace, thereby forming a silicon dioxide film 16 with a thickness of 4 nm working as a base. Figure 16(b) shows a concentration profile of silicon atoms and oxygen atoms included in the semiconductor substrate 10 in which the silicon dioxide film 16 has been formed, wherein the interface between the silicon dioxide film 16 and the semiconductor substrate 10 is shown with a dashed line.

Then, the semiconductor substrate 10 is subjected to a first nitriding process at a temperature of 800°C for 20 minutes at a high pressure of 25 atmospheric pressure in an atmosphere of a laughing gas. As a result, a prior nitrided oxide film 17 with a thickness of 5 nm is formed as is shown in Figure 17(a).

Figure 17(b) shows a concentration profile of silicon atoms, oxygen atoms and nitrogen atoms included in the insulating film and the semiconductor substrate 10 in which the prior nitrided oxide film 17 has been formed. The peak point in the concentration profile of the nitrogen atoms is present in the gate insulating film 12 in the vicinity of the interface close to the semiconductor substrate 10, and the concentration of the nitrogen atoms at the peak point in the concentration profile is approximately 3 atom%.

Next, the semiconductor substrate 10 is subjected to a second nitriding process (RTN process) at a temperature of, for example, 850°C for 10 seconds in a nitrous oxide gas by using an RTP apparatus having a heating lamp. As a result, an ultimate nitrided oxide film 18 with a thickness of 5 nm is formed as is shown in Figure 18(a).

Figure 18(b) shows a concentration profile of silicon atoms, oxygen atoms and nitrogen atoms included in the insulating film and the semiconductor substrate 10 in which the ultimate nitrided oxide film 18 has been formed. The peak points in the concentration profile of the nitrogen atoms are present in the gate insulating film 12 not only in the vicinity of the interface close to the semiconductor substrate 10 but also in the vicinity of the interface close to the gate electrode 13, and the concentrations of the nitrogen atoms at the peak points in the concentration profile are both approximately 3 atom%.

Next, similarly to the fourth embodiment, the gate electrode 13 is formed on the gate insulating film 12 made of the nitrided oxide film 18, and an N type impurity is implanted by using the gate electrode 13 as a mask, thereby forming the N⁺ type high concentration impurity regions 11 working as the source/drain. Thus, the semiconductor device of the third embodiment can be manufactured.

In the ninth embodiment, since the nitrided oxide film 18 with a thickness of 5 nm is formed by conducting the nitriding process on the semiconductor substrate 10 at a high pressure of 25 atmospheric pressure, the concentrations of the nitrogen atoms at the peak points in the concentration profile can be set at approximately 3 atom%, and the lowest concentration of the nitrogen atoms between the peak points in the concentration profile can be set to be slightly high.

Also, similarly to the eighth embodiment, after forming the silicon dioxide film 16 working as a base, the first nitriding process in a laughing gas and the second nitriding process in a nitrous oxide gas are carried out. Therefore, the peak points of the nitrogen atoms in the concentration profile can be set in the gate insulating film 12 in the vicinity of the interface close to the semiconductor substrate 10 as well as the interface close to the gate electrode 13.

In this embodiment, the silicon dioxide film 16 working as a base is formed by the RTO, but the silicon dioxide film 16 can be formed out of a deposited oxide film. Also, without forming the silicon dioxide film 16 working as a base, the semiconductor substrate 10 can be directly treated in a laughing gas or a nitrous oxide gas, so as to set the peak point of the nitrogen atoms in the concentration profile in the gate insulating film 12 in the vicinity of the interface close to the semiconductor substrate 10.

## Claims

1. A semiconductor device comprising a semiconductor layer, an insulating film, a conductive film formed successively in a vertical direction,
wherein said insulating film is made from a silicon dioxide film including nitrogen atoms, and has a peak point in a concentration distribution of the nitrogen atoms in said silicon dioxide film in the vicinity of an interface close to said semiconductor layer.

2. The semiconductor device of Claim 1,
wherein a concentration of the nitrogen atoms at said peak point in the concentration distribution of the nitrogen atoms is 1.5 atom% or more and 5 atom% or less.

3. A semiconductor device comprising a semiconductor layer, an insulating film and a conductive film formed successively in a vertical direction,
wherein said insulating film is made from a silicon dioxide film including nitrogen atoms, and has a first peak point in a concentration distribution of the nitrogen atoms in said silicon dioxide film in the vicinity of an interface close to said semiconductor layer and a second peak point in the concentration distribution of the nitrogen atoms in said silicon dioxide film in the vicinity of an interface close to said conductive film.

4. The semiconductor device of Claim 3,
wherein concentrations of the nitrogen atoms at said first and second peak points in the concentration distribution of the nitrogen atoms are 1.5 atom% or more and 5 atom% or less.

5. The semiconductor device of Claim 4,
wherein a lowest concentration of the nitrogen atoms between said first peak point and said second peak point is 0.1 atom% or more.

6. A method of manufacturing a semiconductor device including a semiconductor layer, an insulating film and a conductive film formed successively in a vertical direction,
wherein a step of forming said insulating film includes an oxide film forming step of forming a silicon dioxide film on said semiconductor layer, and a nitrided oxide film forming step of changing said silicon dioxide film into a nitrided oxide film by conducting a heating process on said silicon dioxide film in an oxidation atmosphere including nitrogen atoms.

7. The method of manufacturing a semiconductor device of Claim 6,
wherein said oxidation atmosphere including nitrogen atoms adopted in said nitrided oxide film forming step is an atmosphere of a N₂O gas or a mixed gas including a NO gas and an O₂ gas.

8. The method of manufacturing a semiconductor device of Claim 6,
wherein said heating process conducted in said nitrided oxide film forming step is carried out at a high pressure.

9. The method of manufacturing a semiconductor device of Claim 6,
wherein said step of forming said insulating film includes a step of nitriding said nitrided oxide film of silicon by conducting a rapid thermal process on said nitrided oxide film of silicon in an atmosphere of a NO gas or a N₂O gas.

10. A method of manufacturing a semiconductor device including a semiconductor layer, an insulating film and a conductive film formed successively in a vertical direction,
wherein a step of forming said insulating film includes a nitrided oxide film forming step of growing a nitrided oxide film of silicon on said semiconductor layer by conducting a heating process on said semiconductor layer in an oxidation atmosphere including nitrogen atoms.

11. The method of manufacturing a semiconductor device of Claim 10,
wherein said oxidation atmosphere including nitrogen atoms adopted in the nitrided oxide film forming step is an atmosphere of a N₂O gas or a mixed gas including a NO gas and an O₂ gas.

12. The method of manufacturing a semiconductor device of Claim 10,
wherein said heating process conducted in said nitrided oxide film forming step is carried out at a high pressure.

13. The method of manufacturing a semiconductor device of Claim 10,
wherein said step of forming said insulating film includes a step of nitriding said nitrided oxide film of silicon by conducting a rapid thermal process on said nitrided oxide film of silicon in an atmosphere of a NO gas or a N₂O gas.
